# EUROPEAN PATENT APPLICATION

(11) **EP 1 172 867 A2**
(43) Date of publication of application: **16.01.2002**
(21) Application number: 01305791.4
(22) Date of filing: 04.07.2001
(51) Int. Cl.: H01L 33/00

(54) **Method for producing P-Type Gallium Nitride-Based compound semiconductor, method for producing Gallium Nitride-Based compound semiconductor light-emitting device, and gallium nitride-based compound semiconductor light-emitting device**

(30) Priority: 10.07.2000 JP 2000207701
(71) Applicant: SHOWA DENKO KABUSHIKI KAISHA, Minato-ku, Tokyo (JP)
(72) Inventor: Hasayuki, Miki, Chichibu-shi, Saitama (JP); Okuyama, Mineo, Chichibu-shi, Saitama (JP); Oshima, Masaharu, Bunkyo-ku, Tokyo (JP); Fujioka, Hiroshi, Bunkyo-ku, Tokyo (JP); Waki, Ichitaro, Bunkyo-ku, Tokyo (JP)
(74) Representative: Smith, Norman Ian

(57) **Abstract**

A method for producing a p-type gallium nitride-based compound semiconductor includes a first step of producing a gallium nitride-based compound semiconductor layer (3) doped with a p-type impurity; a second step of producing a catalyst layer (7) comprising a metal, alloy or compound on the gallium nitride-based compound semiconductor layer; and a third step of annealing the gallium nitride-based compound semiconductor layer with the catalyst layer fixed thereto.

## Description

The present invention relates to a method for producing a p-type gallium nitride-based compound semiconductor, a method for producing a gallium nitride-based compound semiconductor light-emitting device, and a gallium nitride-based compound semiconductor light-emitting device produced by the latter method.

In the field of gallium nitride-based compound semiconductor, it has been long difficult to form a semiconductor showing p-type conductivity. The reasons therefor are considered as follows.

A metal organic chemical vapor deposition (MOCVD) method is generally used for growing a gallium nitride-based compound semiconductor having good crystallinity. However, in the growing apparatus of performing the crystal growth by the MOCVD method, a hydrogen gas used as a carrier gas for transporting a starting material compound onto a substrate, a hydrogen molecule generated upon decomposition of ammonia (NH₃) used as a Group-V starting material such as nitrogen, or a radical or atomic hydrogen is present in a high concentration. Such hydrogen is taken in inside the crystal during the growth of the crystal layer of gallium nitride-based compound semiconductor and bonds to the doped p-type impurity at the cooling from the growing temperature. The p-type impurity thus passivated by the hydrogen is not activated and generates no hole. Therefore, a semiconductor showing p-type conductivity can be hardly formed.

On the other hand, it has been found that the p-type impurity passivated by hydrogen in a semiconductor is dehydrogenated and activated by a method of irradiating a low energy electron beam on Mg-doped gallium nitride (JP-A-2-257679) or a method of annealing Mg-doped gallium nitride in an atmosphere containing no hydrogen (JP-A-5-183189) to enable a semiconductor showing p-type conductivity to be obtained.

However, the method of using electron-beam irradiation has a problem in that the whole surface of a wafer cannot be uniformly treated or even if treated, the treatment takes a long period of time or calls for large and expensive equipment. Therefore, the annealing method capable of homogeneously treating a sample having a wide area is considered industrially suitable for forming a p-type gallium nitride compound semiconductor. However, according to the annealing method disclosed in JP-A-5-183189, the annealing must be performed at a high temperature on the order of 700 to 900°C for ensuring a high carrier concentration. If the annealing is performed at such a high temperature, the crystal constituting the light-emitting layer is readily damaged. For example, InₓGa₁₋ₓN (0<x ≦ 1), which is a ternary mixed-crystal gallium nitride-based compound semiconductor containing In, causes a spinodal decomposition to readily damage the crystal. As a result, a visible light emitting device having sufficiently high light emission intensity cannot be obtained.

JP-A-11-186605 discloses a technique of forming an electrode having good flatness, wherein in the method of forming an electrode for a p-type gallium nitride-based compound semiconductor, Pt is formed on a layer doped with an acceptor impurity and thereafter annealed at a temperature of 400°C or more in an atmosphere containing at least oxygen. At this time, it states not only the formation of an electrode having good flatness but also the activation of the acceptor impurity (p-type impurity) contained inside the crystal.

JP-A-11-145518 discloses a method of producing a p-type gallium nitride-based compound semiconductor, wherein Co is deposited on the surface of a gallium nitride-based compound semiconductor doped with an acceptor impurity and then annealed in an oxygen atmosphere, and thereafter the oxidized Co-film is removed. This method is proposed to enable the annealing temperature to be lowered, the damages on the thin film structure inside the crystal to be reduced, and good surface morphology to be kept.

The aforementioned methods of JP-A-11-186605 and JP-A-11-145518 belonging to a technique of forming a metal thin film on the surface and using a mixed gas containing oxygen as the vapor phase atmosphere gas used at the annealing to lower the annealing temperature have, however, a problem in that although the annealing temperature can surely be lowered, contamination containing oxygen remains on the surface of the gallium nitride-based compound semiconductor and cannot be easily removed. This contamination is an insulating metal oxide in many cases and inhibits the electrical contact of gallium nitride-based compound semiconductor with an electrode metal and therefore, the electrode formed on the surface is increased in the contact resistance. Moreover, these contaminants form a solid solution with a solid constituting the crystal due to the temperature at the annealing and in many cases, enter into the inside to exist there rather than on the outermost surface and therefore, complete removal thereof is difficult.

To cope with this, a technique of performing the annealing in an atmosphere gas containing no oxygen at a low temperature to obtain p-type conductivity is disclosed in JP-A-11-177134 and JP-A-11-354458. According to this technique, a thin film of Pd is formed as a hydrogen-occluded metal on the surface of a gallium nitride-based compound semiconductor doped with an acceptor impurity, and then annealed in an inert gas such as nitrogen gas, whereby the p-type impurity passivated by hydrogen in the semiconductor is dehydrogenated and activated to obtain a semiconductor showing p-type conductivity. By this technique, the deterioration of crystal and the generation of contamination containing oxygen can be surely prevented.

However, the methods of JP-A-11-177134 and JP-A-11-354458 have a problem in that since a noble metal of Pd is formed on the surface, the product costs highly. Furthermore, in the case of removing Pd from the surface and newly forming an electrode, Pd is difficult to remove. Therefore, a treatment with a strong acid at a high temperature or a treatment by irradiating a high-energy ray becomes necessary and this disadvantageously damages the surface of the device structure and makes it difficult to form an electrode by ohmic contact.

The present invention has been made under these circumstances and the objects of the present invention are to provide a method for producing a p-type gallium nitride-based compound semiconductor, to provide a method for producing a gallium nitride-based compound semiconductor light-emitting device and to provide a gallium nitride-based compound semiconductor light-emitting device produced by the latter method, in each of which exertion of p-type conductivity, low-cost production and good ohmic contact with electrode can be realized without incurring deterioration of the crystal in the light-emitting layer or causing contamination or generation of damages on the device surface.

For attaining these objects, the invention provides a method for producing a p-type gallium nitride-based compound semiconductor, comprising a first step of producing a gallium nitride-based compound semiconductor layer doped with a p-type impurity, a second step of producing a catalyst layer comprising a metal, alloy or compound on the gallium nitride-based compound semiconductor layer, and a third step of annealing the gallium nitride-based compound semiconductor layer with the catalyst layer fixed thereto.

In the above method, the catalyst layer can comprise a metal, alloy or compound having a smaller heat of formation for a metal hydride compound than that of the p-type impurity.

The catalyst layer having the smaller heat of formation for a metal hydride compound may be a monolayer or multilayer film comprising a metal, alloy or compound containing at least one element selected from the group consisting of Ni, Co, Fe, Mn, Cr, V, Ti, Re, W, Ta, Hf, Lu, Gd, Ce, La, Ru, Mo, Zr, Y, Au, Ag, Cu, Al and Bi.

The catalyst layer having the smaller heat of formation for a metal hydride compound may be a monolayer or multilayer film comprising a metal, alloy or compound containing Ni.

The annealing in the third step is performed at a temperature of 200°C or more.

The method can further comprise a fourth step of stripping the catalyst layer taken after the third step.

The catalyst layer has a film thickness of 1 to 100 nm.

The invention further provides a method for producing a gallium nitride-based compound semiconductor light-emitting device having an n-type layer, a light-emitting layer and a p-type layer each comprising a gallium nitride-based compound semiconductor, wherein the p-type layer is formed by a first step of producing a gallium nitride-based compound semiconductor layer doped with a p-type impurity, a second step of producing a catalyst layer comprising a metal, alloy or compound on the gallium nitride-based compound semiconductor layer, a third step of annealing the gallium nitride-based compound semiconductor layer with the catalyst layer fixed thereto, and a fourth step of stripping the catalyst layer.

In the method just mentioned above, the catalyst layer can comprise a metal, alloy or compound having a smaller heat of formation for a metal hydride compound than that of the p-type impurity.

The catalyst layer having the smaller heat of formation for a metal hydride may be a monolayer or multilayer film comprising a metal, alloy or compound containing at least one element selected from the group consisting of Ni, Co, Fe, Mn, Cr, V, Ti, Re, W, Ta, Hf, Lu, Gd, Ce, La, Ru, Mo, Zr, Y, Au, Ag, Cu, Al and Bi.

The catalyst layer is a monolayer or multilayer film comprising a metal, alloy or compound containing Ni.

The annealing in the third step is performed at a temperature of 200°C or more.

The catalyst layer has a film thickness of 1 to 100 nm.

The invention further provides a gallium nitride-based compound semiconductor light-emitting device having an n-type layer, a light-emitting layer and a p-type layer each comprising a gallium nitride-based compound semiconductor, wherein the p-type layer is formed by producing a catalyst layer comprising a metal, alloy or compound on a gallium nitride-based compound semiconductor layer doped with a p-type impurity, annealing the gallium nitride-based compound semiconductor layer with the catalyst layer fixed thereto, stripping the catalyst layer, and activating the p-type impurity in the p-type layer.

The above and other objects, features and advantages of the present invention will become apparent from the description give herein below with reference to the accompanying drawings, in which:
Figure 1 is a view for explaining the procedure in the method of the present invention for producing a gallium nitride-based compound semiconductor,
Figure 2 is a plan view schematically showing the annealing furnace for use in the annealing of a sample, and
Figure 3 is a graph showing the relationship between the annealing temperature and the carrier concentration,
Figure 4 is a view for explaining the method for producing a semiconductor light-emitting device constituted using the p-type gallium nitride-based compound semiconductor produced according to the method of the present invention.

The present invention will now be described with reference to the illustrated embodiments.

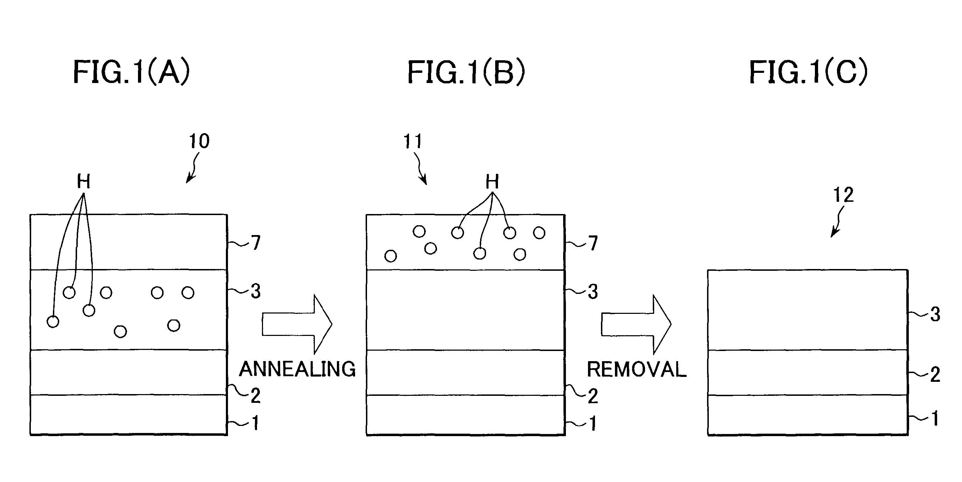

Figure 1 is a view for explaining the procedure in the method of the present invention for producing a p-type gallium nitride-based compound semiconductor. The method of the present invention for producing a p-type gallium nitride-based compound semiconductor will be described using this figure. As shown in Figure 1(A), a buffer layer 2 comprising GaN, a p-type layer 3 comprising GaN doped with Mg and a catalyst layer 7 comprising Ni are formed on a substrate 1 comprising sapphire to construct a multilayer structure (sample) 10. The sample 10 thus obtained is annealed at 300°C for 10 minutes. By this annealing, hydrogen bonded to Mg in the p-type layer 3 migrates and as shown in Figure 1(B), bonds to Ni in the catalyst layer 7. The resulting sample 11 is impregnated with hydrochloric acid to remove the catalyst layer 7, thereby forming a sample 12 shown in Figure 1(C). In the p-type layer 3 of this sample 12, Mg passivated by bonding to hydrogen at the step of the sample 10 is activated to increase the carrier concentration, so that the p-type layer 3 can fully exert the p-type function.

This production method will be described in greater detail below. First of all, the substrate 1 was introduced into a quartz-made reaction furnace provided within an RF coil of an induction heater. The substrate 1 was placed on a carbon-made susceptor for heating. After the introduction of the sample, the reaction furnace was vacuumized to discharge the air and a nitrogen gas was caused to flow therein to purge the inside of the reaction furnace.

After flow of the nitrogen gas over 10 minutes, the induction heater was actuated to elevate the substrate temperature to 1,170°C over 10 minutes. With the temperature kept at 1,170°C, the substrate was left standing for 9 minutes while flowing a hydrogen gas and a nitrogen gas to perform thermal cleaning of the substrate surface.

During the thermal cleaning, a hydrogen carrier gas was flown into the reaction furnace through pipes of containers (bubblers) containing trimethyl gallium (TMG) or cyclopentadienyl magnesium (Cp₂Mg) as starting materials to initiate bubbling. Here, the pipes were connected to the reaction furnace. Each bubbler was adjusted to a constant temperature using a thermobath for the temperature adjustment. The starting material gases generated by the bubbling each was flown together with the carrier gas into a pipe connected to a deharmarizing system and discharged outside the system through the deharmarizing system.

After completion of the thermal cleaning, the induction heater was controlled to lower the temperature of the substrate 1 to 510°C and the valve for the carrier gas comprising nitrogen was changed over to start feeding of nitrogen into the reaction furnace. Ten minutes after that, the valve of the pipe for TMG and the valve of the pipe for ammonia were changed over to feed TMG and ammonia into the reaction furnace, thereby forming a buffer layer 2 comprising GaN on the substrate. The buffer layer 2 was grown over about 10 minutes and thereafter, the valve of the pipe for TMG was changed over to stop feeding of TMG and finish the growth of the buffer 2.

After the formation of the buffer layer 2, the temperature of the substrate 1 was elevated to 1,060°C. During the elevation of temperature, an ammonia gas was flown into the reaction furnace in addition to the nitrogen and hydrogen carrier gases, so as to prevent the buffer layer 2 from sublimating. After confirming that the temperature was stabilized at 1,060°C, the valves of pipes for TMG and Cp₂Mg were changed over to feed a gas containing these starting material gases into the reaction furnace, thereby growing a p-type layer 3 comprising Mg-doped GaN on the buffer layer 2.

The p-type layer was grown over about 2 hours and thereafter, the valves of pipes for TMG and Cp₂Mg were changed over to stop feeding the starting materials into the reaction furnace and finish the growth.

After the completion of growth of the p-type layer 3, the induction heater was controlled to lower the temperature of the substrate 1 to room temperature over 20 minutes. During the lowering of temperature, the atmosphere inside the reaction furnace was composed of ammonia, nitrogen and hydrogen similarly to the atmosphere during the growth, but after confirming that the temperature of the substrate 1 was lowered to 300°C, the feeding of ammonia and hydrogen was stopped. Thereafter, the substrate temperature was lowered to room temperature while flowing a nitrogen gas and then the sample was taken out into atmosphere.

Subsequently, a Ni thin film was formed as a catalyst layer 7 by vapor deposition on the surface of the obtained sample.

First of all, the sample was cleaned. After ultrasonic cleaning in acetone for 10 minutes, the sample was transferred into an ion-exchanged water and water-washed for 3 minutes while overflowing water. Thereafter, the sample was placed in hydrochloric acid poured into a beaker, left standing as it was for 10 minutes and then, again water-washed for 3 minutes in the beaker while overflowing water.

The sample, the surface of which was thus washed, was fixed in a vacuum evaporator. The sample was placed on a fixture such that the sample surface faced downward and then, a small amount of Ni material was placed on a tungsten-made boat for resistance heating disposed under the fixture. Thereafter, a bell jar was closed and the inside thereof was decompressed to 3×10⁻⁶ Torr using an oil rotary pump and an oil-diffusion pump.

After confirming the degree of vacuum, a current was passed to the boat for resistance heating while observing the boat through a window for inspecting the inside of bell jar and after confirming that the Ni material was completely dissolved, the shutter intercepting the boat from the sample was opened. Thereafter, the current value was elevated while monitoring the film formation rate by a quartz-plate film-thickness meter and when the catalyst layer 7 comprising a Ni thin film reached a film thickness of 10 nm, the shutter was again closed.

After the completion of vapor deposition, the sample was left standing for about 15 minutes to allow the boat to cool, the bell jar was then released and the sample was taken out therefrom.

Through these steps, a sample 10 composed of a substrate 1, a buffer layer 2 having a film thickness of 20 nm, a p-type layer 3 comprising GaN doped with 1×10²⁰ cm⁻³ of Mg and having a film thickness of 2 µm, and a catalyst layer 7 comprising a Ni thin film, was fabricated.

Subsequently, the sample 10 was annealed in the following manner to manufacture a sample 11 having a p-type layer 3 capable of exerting electrical conductivity.

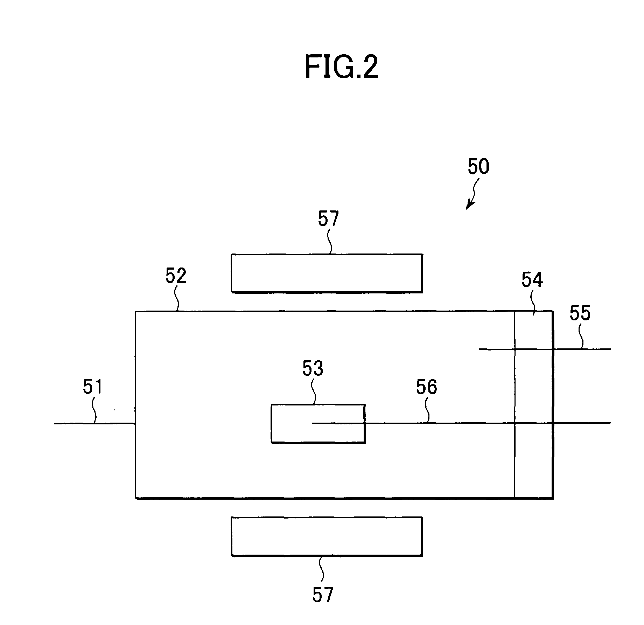

Figure 2 is a plan view schematically showing an annealing furnace 50 for use in the annealing of the sample 10. The annealing furnace 50 is an infrared gold furnace designed so that a carbon-made susceptor 53 can be disposed inside a quartz-made reactor tube 52 into which various gases can flow through a gas inlet 51. The annealing furnace 50 has a vacuum pump (not shown) connected thereto through a vacuum flange 54 and a gas outlet 55, and the inside of the reactor tube 52 can be vacuumized. Into the inside of the carbon-made susceptor 53, a thermocouple 56 for monitoring the temperature can be inserted and based on a signal from the thermocouple 56, the power of an infrared heater 57 and the temperature of the sample 10 can be controlled.

Using the annealing furnace 50, the sample 10 was annealed as follows.

At first, the susceptor 53 was taken out from the reaction tube 52, and the sample 10 was placed thereon. The susceptor 53 was again inserted into the reaction tube 52, and the vacuum flange 54 was fixed. Thereafter, the inside of the reactor tube 52 was vaccumized by the vacuum pump and purged with a nitrogen gas as an atmosphere gas for use in the annealing. After repeating this operation three times, the inside of the reactor tube 52 was returned to atmospheric pressure, and the atmosphere gas was flown into the inside of the reactor tube 52 at a flow rate of 0.5 sccm for 5 minutes.

After the five-minute flow of the atmosphere gas, the infrared heater 57 was turned on to elevate the temperature of the sample 10. While still flowing the atmosphere gas at the same flow rate, the temperature of the sample 10 was elevated to 300°C over 8 minutes and after keeping the sample at 300°C for 10 minutes, the current of the infrared heater 57 was set to 0 to stop heating the sample 10. At the same time, a nitrogen gas as the atmosphere gas was changed over to a cooling gas comprising only nitrogen, and the cooling gas was flown at a flow rate of 40 sccm. In this state, the temperature of the sample was lowered to room temperature over 15 minutes.

After confirming that the susceptor 53 was at room temperature, the inside of reactor tube 52 was vacuumized by the vacuum pump and purged with a nitrogen gas, then the vacuum flange 54 was released, the susceptor 53 was taken out outside, and a sample 11 thus annealed was recovered.

Thereafter, the sample 11 was impregnated with hydrochloric acid adjusted to room temperature for 10 minutes so as to remove the catalyst layer 7 comprising Ni formed on the sample surface. By this treatment, the Ni thin-film formed on the surface was dissolved. As a result, a sample 12 was obtained. The surface of the sample 12 lost the metal color and restored to the colorless and transparent color inherent in GaN.

Subsequently, the carrier concentration of the p-type layer 3 comprising a Mg-doped GaN of the sample 12 resultant from the annealing was measured. The measurement of the carrier concentration was performed as follows using the Hall effect measurement of the van der Pauw's method.

The sample cut into a 7-mm square was impregnated with acetone in a beaker for 10 minutes under application of an ultrasonic wave, then impregnated with hydrochloric acid for 10 minutes and washed with running water for 3 minutes. Thereafter, a circular electrode comprising Ni and having a diameter of 0.5 mm and a film thickness of 3,000 Å was formed at the four corners of the sample by vapor deposition using a metal mask. In order to form ohmic contact between each electrode and the sample, the sample was annealed at 450°C for 10 minutes in an argon atmosphere.

The Hall effect measurement was performed by passing a current of 10 µA to the sample in a magnetic field of 3,000 G. The contact properties of the electrode showed ohmic properties and this reveals that the measurement was exactly performed. As a result of this measurement, it was found that the Mg-doped GaN layer 3 showed p-type conductivity and that the carrier concentration was 9×10¹⁶ cm⁻³.

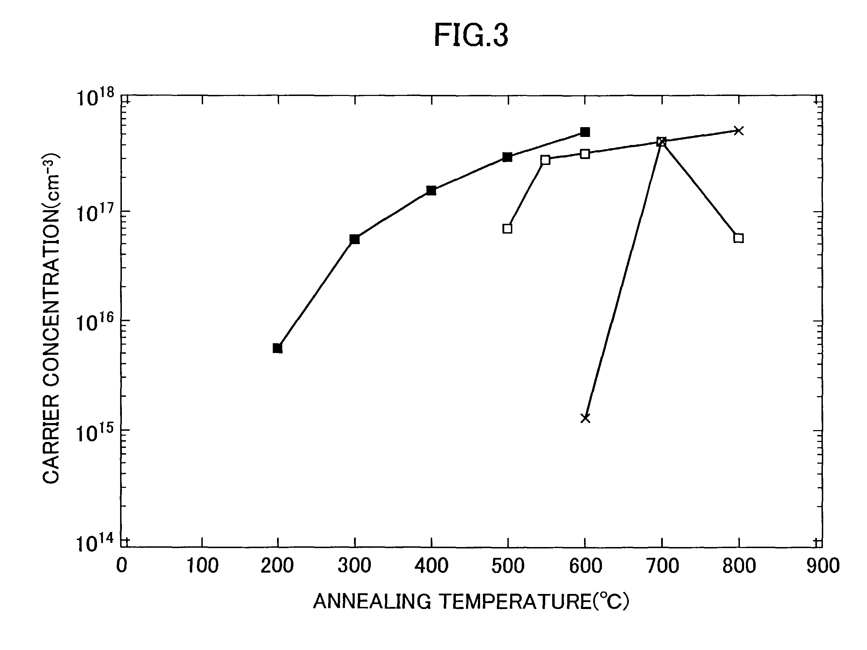

The sample 12 was produced by performing the annealing at a temperature of 300°C in a nitrogen gas atmosphere for allowing the p-type layer 3 after the formation of catalyst layer 7 to exhibit electrical conductivity. Here, in order to understand the relationship between the annealing temperature and the carrier concentration, samples were produced under the same conditions except for setting the annealing temperature not only at 300°C but also at 200°C, 400°C, 500°C or 600°C, and the carrier concentration of the p-type layer 3 of each sample was measured. Figure 3 shows the measurement results, where the carrier concentrations are plotted by the mark ■.

### (Comparative Example 1)

In the same manner as in the first embodiment, a GaN layer was formed on a sapphire substrate and a Mg-doped GaN layer is stacked thereon to form a sample. This sample was annealed using the same annealing furnace 50 as used in the first embodiment. The annealing was performed at 300°C for 10 minutes in a nitrogen gas atmosphere in the same manner as in the first embodiment except that in Comparative Example 1, a catalyst layer was not formed on the sample surface.

The thus annealed sample was measured on the carrier concentration of the Mg-doped GaN layer in the same manner as in the first embodiment. The Mg-doped GaN layer (p-type layer) showed high resistance and therefore, the carrier concentration thereof could not be measured. It is conceivable that this is because Mg in the p-type layer bonds to hydrogen to be inactivated.

Also, samples were produced under the same conditions except for elevating the annealing temperature to 600°C, 700°C or 800°C, and the carrier concentration of the p-type layer of each sample was measured. Figure 3 shows the measurement results, where the carrier concentrations are plotted by the mark ×.

### (Comparative Example 2)

In the same manner as in the first embodiment, a GaN layer is formed as a buffer layer on a sapphire substrate, a Mg-doped GaN layer is stacked thereon and a catalyst layer of Ni thin film is further formed thereon to produce a sample. This sample was annealed using the same annealing furnace 50 as used in the first embodiment. The annealing of this sample was performed for 10 minutes in the same manner as in the first embodiment except that in Comparative Example 2, the annealing temperature was set at 500°C and a nitrogen gas containing 10% of oxygen was used as the atmosphere gas at the annealing, thereby producing a p-type GaN layer.

The thus annealed sample was measured on the carrier concentration of the Mg-doped GaN layer (p-type layer) in the same manner as in the first embodiment. In Comparative Example 2, a catalyst layer of Ni thin film was formed and subjected to annealing. Therefore, the Mg-doped GaN layer showed electrical conductivity and the carrier concentration was 1×10¹⁷ cm⁻³. The carrier concentration was substantially equal to that in the first embodiment. However, when the outermost surface of the GaN layer (p-type layer) was observed by AES (Auger electron spectrometry), it was found that Ni oxide or Ga oxide was present on the surface of the GaN layer due to contamination generated upon annealing and that the morphology and the contact property were damaged.

Also, samples were produced under the same conditions except for elevating the annealing temperature to 550°C, 600°C, 700°C or 800°C, and the carrier concentration of the p-type layer of each sample was measured. Figure 3 shows the measurement results, where the carrier concentrations are plotted by the mark □.

As seen from Figure 3, in the samples (mark ■) produced according to the method of the present invention, the p-type layer 3 exhibits a sufficiently high carrier concentration even by annealing at a temperature as low as 300°C. This is attributable to the fact that, as described above, a Ni thin film is used as a catalyst layer 7 and hydrogen is bonded to Ni in the catalyst layer 7, so that Mg in the p-type layer 3 is activated.

On the other hand, in Comparative Example 1 (mark ×), a catalyst layer is not used and therefore, the acceptor impurity (Mg in this case) in the p-type layer remains bonding to hydrogen. As a result, a sufficiently high carrier concentration can be obtained only at a high temperature of 700°C. With a temperature in the region higher than that, the thermal decomposition of the gallium nitride-based compound semiconductor is accelerated to cause splitting off of the Group V element in the crystal. From the defects after the splitting off of Group V element, an electron is produced and therefore, a phenomenon that the carrier concentration decreases occurs as in the case of the carrier concentration at 800°C. Accordingly, annealing for a long period of time at a temperature of 700°C or more is not preferred. The annealing is optimally performed at a temperature of 200 to 600°C and in order to attain sufficiently high activity of the acceptor impurity, the annealing is preferably performed at a temperature of 300°C or more.

In Comparative Example 2 (mark □), a catalyst of Ni thin film is used but since oxygen is contained in the atmosphere gas, despite a sufficiently high carrier concentration, Ni oxide or Ga oxide is present on the surface of the p-type layer due to generation of contamination and therefore, the morphology and the contact property are damaged.

As such, according to the method of the present invention, since a desired carrier concentration can be obtained even by annealing at a low temperature, the crystal in the light-emitting layer is not damaged and also, since the annealing is performed in a nitrogen gas atmosphere, contamination does not occur.

Furthermore, since the metal constituting the catalyst layer 7 is not necessary to be a noble metal such as Pd, the cost can also be reduced.

For removing the layer comprising a noble metal such as Pd, a treatment with a strong acid at a high temperature or a treatment by the irradiation of a high-energy ray is necessary. As a result, the surface after the removal becomes coarse to give damages thereto. On the other hand, since Ni or the like is used in the present invention, the catalyst layer can be swiftly removed without causing any damage on the surface and accordingly, good ohmic contact can be realized with an electrode which is afterward formed on the surface.

In the first embodiment, the film thickness of the catalyst layer 7 formed on the p-type layer 3 is preferably on the order of 1 to 100 nm. For bonding hydrogen atoms diffusing from the crystal of p-type layer 3, it is sufficient if the constituent material of the catalyst layer is present in an amount of this range. If the catalyst layer 7 is excessively thick, the hydrogen atom cannot be eliminated from the catalyst layer into the vapor phase and a phenomenon of the hydrogen atoms again diffusing within the crystal may occur. The numerals of the film thickness set forth here are an optimal value found by the present inventors through the experiments conducted taking account of such a phenomenon.

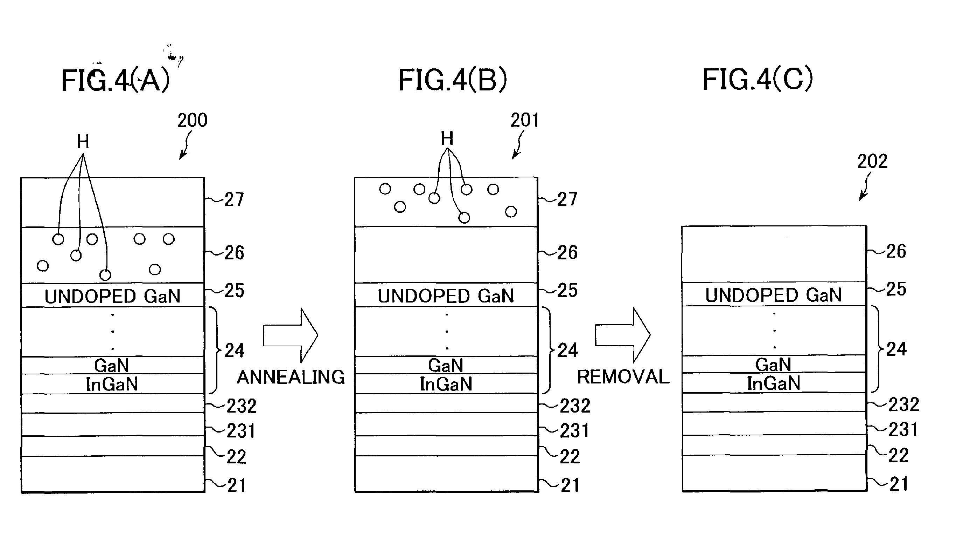

The second embodiment of the present invention will be described below with reference to Figure 4.

Figure 4 is a view for explaining the method for producing a semiconductor light-emitting device (semiconductor light-emitting diode) constituted using the p-type gallium nitride-based compound semiconductor produced according to the method of the present invention.

In the second embodiment, a buffer layer 22 comprising AlN, an n-type layer 231 comprising an undoped GaN, an n-type layer 232 comprising a Si-doped AlGaN, multiquantum well (MQW) layer 24 comprising an InGaN layer and a GaN layer, an undoped GaN layer 25, and a p-type layer 26 comprising a Mg-doped AlGaN were stacked in sequence on a substrate 21 comprising sapphire using the MOCVD method to produce a wafer having a multilayer structure for a semiconductor light-emitting device.

On this wafer having a multilayer structure, a catalyst layer 27 comprising Co and having a film thickness of 1 nm was formed by a resistance heating method in the same manner as in the first embodiment using the same vapor deposition machine as used in the first embodiment to produce a sample 200 as shown in Figure 4 (A). This sample was annealed at 400°C for 5 minutes in a vacuum at a pressure of 3×10⁻³ Torr in the same manner as in the first embodiment using the same annealing furnace 50 as used in the first embodiment. As such, a sample 201 was produced as shown in Figure 4(B). Thereafter, the catalyst layer 27 comprising Co was removed in the same manner as in the first embodiment to produce a sample (wafer) 202 having a p-type layer 26 as the outermost surface, as shown in Figure 4(C).

The carrier concentration of the p-type layer 26 as the outermost surface of the annealed wafer 202 was measured in the same manner as in the first embodiment and it was found that the carrier concentration was about 6×10¹⁶ cm⁻³ and p-type conductivity was exhibited. More specifically, similarly to the first embodiment, hydrogen bonded with Mg in the p-type layer 26 migrated to the catalyst layer 27 by the annealing and bonded with Co in the catalyst 27. As a result, Mg in p-type layer 26, which had been inactivated by bonding with hydrogen, was activated and enabled to freely migrate, and the carrier concentration in the p-type layer 26 was elevated.

On the wafer 202 after the completion of annealing, a bonding pad having a structure such that titanium and gold were stacked, and a transparent electrode having a structure such that gold and nickel oxide were stacked were formed in sequence from the surface side of the p-type electrode 26 by a known photolithography to produce a p-side electrode.

Thereafter, the wafer 202 was dry-etched to expose a portion of the n-type layer 231 where an n-side electrode is to be formed, and an n-side electrode comprising titanium was produced on the exposed portion.

The wafer on which the p-side and n-side electrodes were formed as such was subjected to a treatment of grinding and polishing the back surface of the substrate 21 to provide a mirror surface. Thereafter, the wafer was cut into 350-µm square chips and the square chip was placed on a lead frame such that the electrodes came upward, and bonded to the lead frame through a gold line to fabricate a semiconductor light-emitting diode.

A forward current was passed between the p-side electrode and the n-side electrode of the thus-fabricated semiconductor light-emitting diode. As a result, the forward voltage at a current of 20 mA was 3.6 V. The light emission was observed through the p-side transparent electrode and, as a result, the emission wavelength was 465 mm and the emission power output was 3 cd.

### (Comparative Example 3)

A wafer having a multilayer structure was produced by the MOCVD method in the same manner as in the second embodiment. In the same manner as in the second embodiment, a Co thin film was formed on the surface, the wafer was then annealed for 10 minutes in a nitrogen gas atmosphere to activate Mg in the AlGaN layer and at the same time, the Co thin film was removed to produce a p-type layer comprising AlGaN.

The carrier concentration of the p-type layer as the outermost surface of the annealed wafer was measured in the same manner as in the first embodiment, and it was found that the conductivity was p-type and the carrier concentration was about 7×10¹⁷ cm⁻³.

On the wafer after the completion of annealing, a p-side electrode and an n-side electrode were produced in the same manner as in the second embodiment. Using this wafer, a light-emitting diode was fabricated in the same manner as in the second embodiment.

A forward current was passed between the p-side electrode and the n-side electrode of the thus-fabricated light-emitting diode. As a result, the forward voltage at a current of 20 mA was 5.2 V. The light emission was observed through the p-side transparent electrode. As a result, the emission wavelength and the emission power output were substantially the same as those in the second embodiment.

As such, there was no difference in the emission power output of the light-emitting diode between the second embodiment and Comparative Example 3, but a great different was present in the forward voltage at a current of 20 mA. This is considered to occur because in Comparative Example 3, the annealing was performed in a nitrogen gas atmosphere containing oxygen and therefore, Co oxide or Ga oxide as contamination was generated on the outermost surface of the p-type layer to change the morphology and the contact property for the worse and, as a result, the contact resistance of the p-side electrode was elevated.

### (Comparative Example 4)

A wafer was fabricated almost in the same manner as in the second embodiment except that in the second embodiment, a Co-layer was formed on a p-type layer 26 comprising an Mg-doped AlGaN, whereas in Comparative Example 4, Pd was used in place of Co and the Pd layer was removed using the boiling in aqua regia. The carrier concentration of the p-type layer comprising AlGaN that was the outermost layer of this wafer was about 6×10¹⁷ cm⁻³.

On this wafer, a p-side electrode and an n-side electrode were produced in the same manner as in the second embodiment to fabricate a light-emitting diode.

A forward current was passed between the p-side electrode and the n-side electrode of the thus-fabricated light-emitting diode. As a result, the forward voltage at a current of 20 mA was 6.0 V. The light emission was observed through the p-side transparent electrode. As a result, the emission wavelength and the emission power output were substantially the same as those in the second embodiment.

Similarly to Comparative Example 3, there was no difference in the emission power output of the light-emitting diode between the second embodiment and Comparative Example 4, but a great different was present in the forward voltage at a current of 20 mA. This is considered to occur because in Comparative Example 4, the Pd layer was removed by the boiling in aqua regia and therefore, the outermost layer of the p-type layer became coarse and damaged.

In the foregoing description, the gallium nitride-based compound semiconductor is a Group III-V compound semiconductor based on GaN, where a part of Ga is displaced by a Group III element such as B, In or Al and a part of N is displaced by a Group V element such as As or P. One example is a seven-component gallium nitride-based compound semiconductor represented by formula: (AlₓB_{y}In_{z}Ga_{1-x-y-z})N₁₋ᵢ₋ⱼPᵢAsⱼ, wherein 0 ≦ x ≦ 1, 0 ≦ y ≦ 1, 0 ≦ z ≦ 1, 0 ≦ j ≦ 1, and 0 ≦ i ≦ 1.

In the first embodiment, the annealing was performed in a nitrogen gas atmosphere, but may be performed in another inert gas, for example, in a rare gas such as Ar. Also, in the second embodiment, the annealing was performed in a vacuum of 3×10⁻³ Torr, but the pressure may be sufficient if it is a pressure on the order of not allowing oxidation to proceed and the pressure value is not particularly limited.

Furthermore, the catalyst layer was formed using Ni or Co, but the present invention is not limited thereto and the metal which can be used as a catalyst layer may be sufficient if it is a metal having a smaller heat of formation for a metal hydride compound than that of the p-type impurity. Examples thereof include Fe, Mn, Cr, V, Ti, Re, W, Ta, Hf, Lu, Gd, Ce, La, Ru, Mo, Zr, Y, Au, Ag, Cu, Al and Bi. These metals are known to have energy of bonding with hydrogen larger than that of a p-type impurity such as Mg. By utilizing a catalyst layer comprising a material having such properties, the hydrogen atom whose bonding with the p-type impurity is cut at the annealing migrates in the crystal, contacts with the catalyst layer formed on the surface and more preferentially bonds with a metal constituting the catalyst layer. Accordingly, the hydrogen in the crystal can be more effectively removed.

The catalyst layer was constituted as a monolayer film comprising one metal, but may also be constituted as a multilayer film comprising one metal, or an alloy of two or more metals, or compound.

As described in the foregoing, according to the present invention, a catalyst layer comprising a metal having a smaller heat of formation for the metal hydride compound than that of the p-type impurity is formed on a gallium nitride-based compound semiconductor layer doped with a p-type impurity and the catalyst layer is annealed, so that hydrogen bonded with the p-type impurity bonds with a metal in the catalyst layer. Therefore, the p-type impurity inactivated by hydrogen is activated and freely migrates to elevate the carrier concentration. As a result, the gallium nitride-based compound semiconductor layer doped with the p-type impurity can fully exert the p-type function.

A desired carrier concentration can be obtained even by annealing at a low temperature and therefore, deterioration does not occur in the crystal of the light-emitting layer. Furthermore, contamination is also not generated and accordingly, when a light-emitting device is fabricated, good contact properties can be kept between the p-type gallium nitride-based compound semiconductor layer and the electrode and in turn the properties as a light-emitting device can be improved.

In addition, it is not necessary to use a noble metal such as Pd as the metal constituting the catalyst layer and therefore, the cost can be reduced.

For removing the layer comprising a noble metal such as Pd, a treatment with a strong acid at a high temperature or a treatment by the irradiation of a high-energy ray is necessary. As a result, the surface after the removal becomes coarse to give damages thereto. However, since Ni or the like is used in the present invention, the catalyst layer can be swiftly removed without causing any damage on the surface and accordingly, good ohmic contact can be realized with an electrode which is afterward formed on the surface and, as a result, the properties of the light-emitting device can be improved.

The film thickness of the catalyst layer is from 1 to 100 nm, so that hydrogen atoms diffusing from the crystal in the gallium nitride-based compound semiconductor layer doped with a p-type impurity can be satisfactorily captured and at the same time, a phenomenon that the hydrogen atom does not split off from the catalyst layer into the vapor phase but diffuses again within the crystal, which occurs in the case of a catalyst layer having an excessively large thickness, can be prevented. As a result, the gallium nitride-based compound semiconductor layer doped with a p-type impurity can be converted into a p-type layer without fail.

## Claims

1. A method for producing a p-type gallium nitride-based compound semiconductor, comprising:
a first step of producing a gallium nitride-based compound semiconductor layer (3) doped with a p-type impurity;
a second step of producing a catalyst layer (7) comprising a metal, alloy or compound on said gallium nitride-based compound semiconductor layer; and
a third step of annealing the gallium nitride-based compound semiconductor layer with said catalyst layer fixed thereto.

2. The method for producing a p-type gallium nitride-based compound semiconductor as claimed in claim 1, **characterized in that** said catalyst layer (7) comprises a metal, alloy or compound having a smaller heat of formation for a metal hydride compound than that of the p-type impurity.

3. The method for producing a p-type gallium nitride-based compound semiconductor as claimed in claim 2, **characterized in that** said catalyst layer (7) is a monolayer or multilayer film comprising a metal, alloy or compound containing at least one element selected from the group consisting of Ni, Co, Fe, Mn, Cr, V, Ti, Re, W, Ta, Hf, Lu, Gd, Ce, La, Ru, Mo, Zr, Y, Au, Ag, Cu, Al and Bi.

4. The method for producing a p-type gallium nitride-based compound semiconductor as claimed in claim 2, **characterized in that** said catalyst layer (7) is a monolayer or multilayer film comprising a metal, alloy or compound containing Ni.

5. The method for producing a p-type gallium nitride-based compound semiconductor as claimed in any one of claims 1 to 4, **characterized in that** the annealing in said third step is performed at a temperature of 200°C or more.

6. The method for producing a p-type gallium nitride-based compound semiconductor as claimed in any one of claims 1 to 4, **characterized in that** it further comprises a fourth step of stripping the catalyst layer (7) after said third step.

7. The method for producing a p-type gallium nitride-based compound semiconductor as claimed in any one of claims 1 to 4, **characterized in that** said catalyst layer (7) has a film thickness of 1 to 100 nm.

8. A method for producing a gallium nitride-based compound semiconductor light-emitting device having an n-type layer (231, 232), a light-emitting layer and a p-type layer (26) each comprising a gallium nitride-based compound semiconductor, said method being **characterized in that** said p-type layer is produced by:
a first step of producing a gallium nitride-based compound semiconductor layer (26) doped with a p-type impurity;
a second step of producing a catalyst layer (27) comprising a metal, alloy or compound on said gallium nitride-based compound semiconductor layer;
a third step of annealing the gallium nitride-based compound semiconductor layer with said catalyst layer fixed thereto; and
a fourth step of stripping said catalyst layer.

9. The method for producing a gallium nitride-based compound semiconductor light-emitting device as claimed in claim 8, **characterized in that** said catalyst layer (27) comprises a metal, alloy or compound having a smaller heat of formation for a metal hydride compound than that of the p-type impurity.

10. The method for producing a gallium nitride-based compound semiconductor light-emitting device as claimed in claim 9, **characterized in that** said catalyst layer (27) is a monolayer or multilayer film comprising a metal, alloy or compound containing at least one element selected from the group consisting of Ni, Co, Fe, Mn, Cr, V, Ti, Re, W, Ta, Hf, Lu, Gd, Ce, La, Ru, Mo, Zr, Y, Au, Ag, Cu, Al and Bi.

11. The method for producing a gallium nitride-based compound semiconductor light-emitting device as claimed in claim 9, **characterized in that** said catalyst layer (27) is a monolayer or multilayer film comprising a metal, alloy or compound containing Ni.

12. The method for producing a gallium nitride-based compound semiconductor light-emitting device as claimed in any one of claims 8 to 11, **characterized in that** the annealing in said third step is performed at a temperature of 200°C or more.

13. The method for producing a gallium nitride-based compound semiconductor light-emitting device as claimed in any one of claims 8 to 11, **characterized in that** said catalyst layer (27) has a film thickness of 1 to 100 nm.

14. A gallium nitride-based compound semiconductor light-emitting device having an n-type layer (231, 232), a light-emitting layer and a p-type layer (26) each comprising a gallium nitride-based compound semiconductor, **characterized in that** said p-type layer (26) is formed by producing a catalyst layer (27) comprising a metal, alloy or compound on a gallium nitride-based compound semiconductor layer (26) doped with a p-type impurity, annealing the gallium nitride-based compound semiconductor layer with said catalyst layer fixed thereto, stripping the catalyst layer, and activating the p-type impurity in the p-type layer.
